# EUROPEAN PATENT APPLICATION

(11) **EP 1 045 291 A2**
(43) Date of publication of application: **18.10.2000**
(21) Application number: 00101348.1
(22) Date of filing: 24.01.2000
(51) Int. Cl.: G03F 7/40

(54) **Method of improving the etch resistance of photoresists**

(30) Priority: 17.02.1999 US 250861
(71) Applicant: Infineon Technologies North America Corp., San Jose, CA 95112-6000 (US)
(72) Inventor: Schroeder, Uwe Paul, Poughkeepsie, NY 12601 (US); Kunkel, Gerhard, Fishkill, NY 12524 (US); Gutmann, Alois, Poughkeepsie, NY 12603 (US)
(74) Representative: Patentanwälte Westphal, Mussgnug & Partner

(57) **Abstract**

A photoresist system is provided that is easily structurable and is suitable for deep ultraviolet range patterning. An increased etching resistance to halogen-containing plasma is produced in a lithographically generated photoresist structure by treatment with an etch protectant. The etch protectant comprises predominantly aromatic structures and includes reactive groups that are suitable for chemical reaction with reactive groups of the photoresist. In an embodiment, the photoresist includes a base resin containing no aromatic groups prior to reaction with the aromatic etch protectant. The etch protectant preferably includes an aromatic polycarboxylic acid, aromatic polycarboxylic acid anhydride, or aromatic polycarboxylic acid chloride.

## Description

### BACKGROUND OF THE INVENTION

### 1. Technical Field

This disclosure relates to photolithography in the field of integrated circuit manufacture, and more particularly to a method for improving the etch resistance of photoresists used in such photolithography.

### 2. Background of Related Art

Photolithography is a commonly used technique in the manufacture of integrated circuits for use in computers and other such applications. In photolithography a photoresist layer is formed on a substrate such as, for example, a silicon wafer. The photoresist is then covered with a mask containing a pattern, in transparent and opaque areas, which is intended to be etched onto the substrate. The mask is then exposed to actinic radiation, such as ultraviolet light (UV), X-ray, electron beam, and the like, which is transmitted through the transparent areas of the mask to cause a chemical reaction in corresponding regions of the photoresist. In a negative type photoresist the radiation impacted areas of the photoresist become insoluble in a developing solvent. For example, the radiation can initiate cross-linking, chain growth, photocondensation, or other such reaction to cause a chemical change in the photoresist. In a positive type photoresist the radiation impacted areas become more soluble in a developing solvent. For example, the radiation can cause photodegradation of the photoresist molecular structure. After radiation exposure the photoresist is developed by exposure to the developing solvent which washes away the soluble portions of the photoresist to leave a pattern. After this patterning step an etching process is conducted wherein the substrate is exposed to an acid, for example in a wet etch process, or an ion beam, for example in a dry etch process. The areas of the substrate covered by the remaining photoresist remain unetched. Finally, the remaining photoresist is removed by a suitable solvent or other conventional removal methods, leaving the substrate with a pattern etched therein.

In order to develop more powerful microprocessors, more electronic components must be put into the chip. Since the physical area of the chip is limited this means that the patterns etched into the substrate must become finer with higher resolution. At the present state of technology the patterns are of such fineness that the wavelengths of light used to expose the photoresist have become an important factor, the shorter wavelengths producing a higher resolution image.

Another factor is the thickness of the photoresist layer. The thinner the photoresist, the sharper the image. However, as the photoresist becomes thinner it becomes less able to withstand the etching process. The photoresist can be made more etch resistant by including certain aromatic compounds in their composition. However, these compounds reduce the sensitivity of the photoresist to the shorter wavelengths of radiation desired for the exposure step. For example, photoresists designed for 1930Å UV radiation can have no aromatic content.

U.S. Patent No. 5,173,393 to Sezi et al. discloses a photoresist system in which increased etch resistance to a halogen-containing plasma is provided by treatment of the photoresist with a reagent possessing-an amine function. Sezi et al. employ a photoresist having special reactive groups incorporated into the molecular structure, such as anhydride functionalities, which are reactable with the amine groups of the reagent.

What is needed is a system for increasing the etch resistance of photoresists which can use a wider variety of photoresists.

### SUMMARY OF THE INVENTION

A method is provided herein for producing a photolithographic structure. The method includes (a) providing a photoresist having a base resin containing protected active sites which upon deprotection provide reactive sites and a photoactive component which is responsive to actinic radiation; (b) applying the photoresist to a substrate; (c) exposing selectively patterned areas of said photoresist to an effective dose of said electromagnetic radiation; (d) exposing said photoresist to a developing agent to create a patterned photoresist; (e) deprotecting protected active sites of the base resin to provide reactive sites; (f) reacting the reactive sites resulting from step (e) with an aromatic ring-containing etch protectant to incorporate the etch protectant into the structure of the base resin; and, (g) etching the substrate.

The method described herein advantageously improves the etch resistance of the photoresist while maintaining the sensitivity of the photoresist to the patterning radiation. Moreover, the method can use any type of photoresist. Deprotection of the photoresist is achieved by a process step of the method, thereby eliminating the need for specially tailored photoresists.

### BRIEF DESCRIPTION OF THE DRAWINGS

Various embodiments are described herein below with reference to the drawings wherein:
FIG. 1 illustrates a cross-sectional view of a structure after a step of a method in accordance with this disclosure;
FIG. 2 illustrates a cross-sectional view of the structure after a further step of a method in accordance with this disclosure;
FIG. 3 illustrates a cross-sectional view of the structure after a further step of a method in accordance with this disclosure; and,
FIG. 4 illustrates a cross-sectional view of the structure after a further step of a method in accordance with this disclosure.

### DETAILED DESCRIPTION OF PREFERRED EMBODIMENTS

The etch-resistant photoresist system described herein includes a photoresist that is well-structurable and responds to electromagnetic radiation having a wavelength below about 2500Å. An etch protectant is employed to react with the photoresist after development to incorporate aromatic groups into the photoresist to increase its etch resistance. The etch protectant is preferably an aromatic polycarboxylic acid, acid anhydride, or acid chloride reactant which can be dissolved in water to form an aqueous solution.

More particularly, the photoresist can be a positive or negative photoresist. The photoresist includes a base resin and a photoactive component (i.e., a photoacid generator) and is usually provided in the form of a solution of the base resin and photoactive component in a suitable solvent. Imagewise exposure of the photoresist to actinic radiation (e.g., UV radiation, X-rays, or electron beam radiation) through a mask releases acid from the photoacid generator in the exposed areas of the photoresist. With negative photoresists the exposed areas become less soluble in a developing solvent, for example by cross-linking of the polymer chains of the base resin. With positive photoresists the exposed areas become more soluble, for example by degradation or the formation of more soluble groups on the molecular chain. Aromatic groups tend to block transmission of UV radiation, especially at shorter wavelengths. Hence, for use with 2000A to 2500A UV radiation the base resin should have a reduced amount of aromatic groups ranging from 0% to about 20% by weight of aromatic content. For use with UV radiation having wavelengths of less than 2000A the base resin in the photoresist should contain substantially no aromatic groups.

The base resin includes active sites, or groups, which initially are protected by protecting groups which, in a later deprotecting step of the process herein, are removed to provide reactive groups. Useful reactive groups include hydroxyl (-OH), carboxyl (-COOH), mercapto (-SH), amino (-NH₂), alkylamino (-NHR), imino (-NH-), formyl (-CHO), sulfo (-SO₃H), and phosphono (-P(O)(OH)₂). Hydroxyl and carboxyl are preferred. The active sites can be protected with a suitable blocking agent having protecting groups. Suitable protecting groups include, e.g., benzyloxycarbonyl, trifluoroacetyl, benzyl ester, t-butyl ester, N-hydroxysuccinimide ester, and the like. A preferred blocking agent for the method described herein includes tert-butoxycarbonyl groups (t-BOC).

By way of example, the base resin for the positive or negative photoresist can be selected from polyhydroxystyrene, polymethylmethacrylate, poly(t-butyl)methacrylate, polyvinyl alcohol, polyvinylphenol, polynorbonene, poly(p-formyl)oxystyrene, poly(t-butoxycarbonyloxystyrene), polyvinylpyrrolidone, polymethylisoprenylketone, phenol-formaldehyde polymers, melamine-formaldehyde polymers, and copolymers, blends and derivatives of these resins. Examples of commercially example positive photoresists include M20G available from JSR Co. of Japan and UV2HS available from Shipley Co. An example of a commercially available negative photoresist is DV30N available from Shipley Co.

Photoactive components include photoacid generators such as, for example, diaryliodonium salts, triarylsulfonium salts, and substituted aryldiazonium salts, the salts having counterions such as tetrafluoborate, hexafluoroantimonate, hexafluoroarsenate and hexafluorophosphate. Other photoacid generators are halomethanes, trichlorotriazine, â-naphthol, nitrobenzaldehyde and polyvinylchloride. The photoresist may include additional substances used in conventional resist formulations. These additional substances may include, for example, additional polymers, sensitizers, crosslinking agents, speed enhancers, flexibility enhancers, adhesion enhancers, heat resistance enhancers, and surfactants. Such components are well known in the art. Examples of sensitizers are diazoquinones such as naphthoquinone-(1,2)-diazide sulfonic acid esters, and particularly the 5-sulfonic acid ester of diazonaphthoquinone. Formulated photoresists and photoresist components are widely available from commercial suppliers.

The actinic radiation employed is preferably short wave ultraviolet light having a wavelength of about 2480Å and more preferably far ultraviolet having a wavelength less than about 2000Å (e.g., 1930Å UV). Also useful are X-rays (having a wavelength below about 100Å, and electron beam radiation.

The method of the present invention is performed according the following steps.

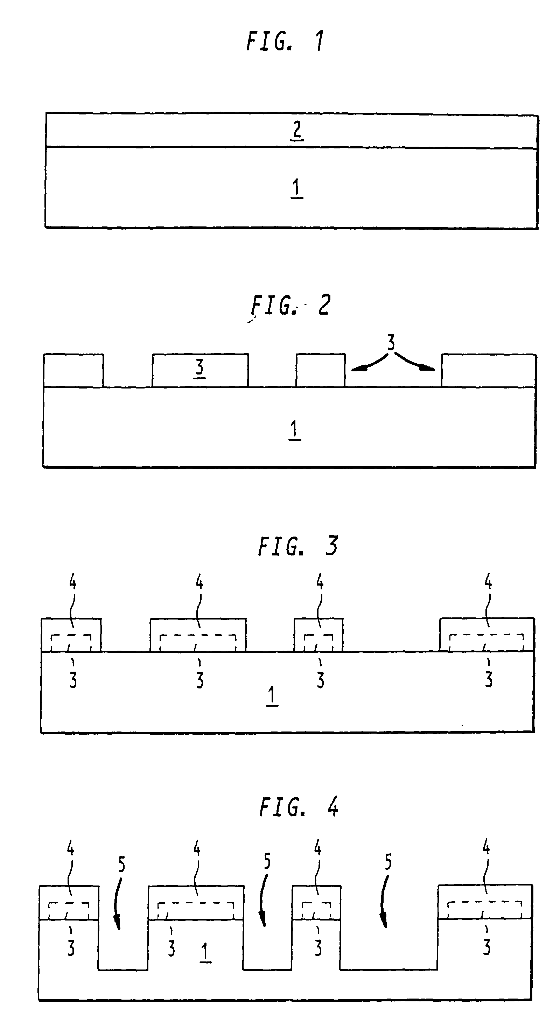

The photoresist is applied to a substrate such as silicon in a conventional manner. Usually, the photoresist solution is applied to a silicon wafer, which is then spun to distribute the photoresist in the form of an even layer over the wafer. The photoresist is then mildly heated to drive off the solvent. The preferred thickness of the photoresist layer is preferably no more than about 1 micron, preferably no more than about 0.8 microns, more preferably no more than about 0.5 microns, and most preferably no more than about 0.3 microns. FIG. 1 illustrates a photoresist layer 2 deposited on a silicon wafer substrate 1.

The photoresist is then patterned as follows. First, the photoresist is masked. The mask can contain lines and other features within a resolution of less than 1.0 micron, preferably less than 0.5 micron, and more preferably less than 0.3 micron. Then the photoresist is exposed to the electromagnetic radiation through the pattern of the mask at a sufficient dose level of actinic radiation, typically from about 50 to about 200 mJ/cm². Next, the photoresist is patterned by exposure to a developing agent. An example of a suitable developing solution is an aqueous solution of developer AZ 400K (available from Hoechst AG) and ammonia. The patterned photoresist is then dried under mild heating.

After development, the patterned photoresist is subjected to a deprotection step to expose the active sites of the base resin for reacting with the etch protectant. The deprotection is accomplished by flood exposure of the patterned photoresist to deep UV radiation (below 2500A) followed by a heat treatment, or baking step. The dosage of UV can be, for example, from about 20mJ/cm² to about 50mJ/cm², although other dosages can also be used as deemed suitable. Under deep UV radiation, acid is generated from the photoacid component of the composition. The acid, in turn, deprotects the base resin during the heat treatment by exposing the active groups (e.g. hydroxyl, carboxyl, etc.). The exposed active groups thus become available for reaction with the etch protectant, and the latter, following reaction with the active groups, become chemically integrated into the polymeric structure of the base resin. The heat activation which achieves deprotection is conducted at a temperature of from about 100°C to about 150°C and for a duration of time ranging from about 1 minute to about 5 minutes. FIG. 2 illustrates the patterned photoresist at this stage of the process having patterned structures 3 on substrate 1.

Next the photoresist is treated with a reactant solution prepared by dissolving a reactive etch protectant in water. The etch protectant is an aromatic ring-containing compound functionalized with groups suitable for reaction with the active, i.e., deprotected, chemical groups on the base resin. As used herein, the term "aromatic" refers to single and multi-ring containing compounds, also including those with both aromatic ring(s) and aliphatic components(s) in the molecular structure. The aromatic ring-containing etch protectant will contain at least one group that undergoes reaction with the active groups of the base resin. Thus, e.g., when the base resin contains free hydroxyl groups, the reactive groups on the etch protectant can be, for example, carboxylic acid, carboxylic acid anhydride or carboxylic acid chloride groups which will react with the hydroxyl groups of the base resin to bond the etch protectant thereto through ester linkages. Suitable etch protectants include phthalic acid, phthalic anhydride, isophthalic acid, terephthalic acid, phthalic acid chloride, naphthalic acid, naphthalic anhydride, naphthyl acetic acid and anthracene dipropionic acid. The polyfunctional acid provides increased etch resistance by contributing aromatic structures to the photoresist structure and by increasing crosslinking. A suitable aqueous reactant solution typically contains from about 0.2% to about 20% by weight of the etch protectant, and more preferably from about 0.5% to about 5% by weight of the etch protectant.

Because no additional measures are required for this step this treatment can be undertaken in a simple apparatus such as, for example, in a spray, puddle, or immersion developer, at room temperature. The reactive groups of the etch protectant enter into a chemical reaction with the reactive sites of the photoresist and this results in the bonding of the etch protectant to the photoresist. As a result of the aromatic structure of the etch protectant, the photoresist is provided with an enhanced etch resistance, especially to halogen-containing plasma.

Referring now to FIG. 3, the patterned photoresist structures 3 include chemically modified surface regions 4 in which aromatic groups are incorporated. The surface regions 4 possess greater etch resistance than unmodified regions.

The photoresist and substrate are then subjected to a known etching process such as wet etching or, preferably, plasma etching. Wet etching is usually accomplished with acid etchants such as hydrofluoric acid. However, wet etching is not suitable for etching lines and spaces of less than about 3 microns because it is an isotropic process. That is, the etching also proceeds laterally through the substrate, thereby undercutting the photoresist. This may cause the polymer photoresist to swell or lift off.

Plasma etching is preferred because it can be performed anisotropically, leaving sharper edge profiles. Plasma etching can be accomplished with halogen-containing etch gases. The halogens react with the substrate to enhance the etching process. Thus, fluorine-containing etch gases are used for etching silicon substrates and chlorine-containing gases are used for etching aluminum substrates. FIG. 4 illustrates the substrate 1, having trenches 5 etched therein.

As noted above, plasma etching also can degrade the photoresist. However, aromatic structures in the photoresist are more resistant to plasma etching. Hence, aromatic photoresist can be formed into thinner layers, which also can produce sharper images.

Treatment with the reactant also causes a swelling of the resist structure. Swelling, due to the reactant treatment, can be an additional, positive benefit, in that it provides a controllable growth layer that creates an etching reserve due to the greater layer thickness. Thus, the resist can be structured in a thin layer with good resolution, and can be thickened with the reactant up to an adequate etch resistance. Also, the photomask can be set to a negative bias towards the target size of the printed structure. By deliberately overexposing the photoresist and adding aromatic groups the final target size of the printed structure can be achieved. This procedure provides a greater flexibility in the process procedures.

It will be understood that various modifications can be made to the embodiments described herein. Therefore, the above description should not be construed as limiting, but merely as exemplifications of preferred embodiments. Those skilled in the art will envision other modifications within the scope of the claims appended hereto.

## Claims

1. A method for producing a photolithographic structure which comprises:
a) providing a photoresist having a base resin containing protected active sites which upon deprotection provide reactive sites and a photoactive component which is responsive to actinic radiation;
b) applying said photoresist to a substrate;
c) exposing selectively patterned areas of said photoresist to an effective dose of said actinic radiation;
d) exposing said photoresist to a developing agent to create a patterned photoresist;
e) deprotecting protected active sites of the base resin to provide chemically reactive sites;
f) reacting the reactive sites resulting from step (e) with an aromatic ring-containing etch protectant and to incorporate the etch protectant into the structure of the base resin; and
g) etching the substrate.

2. The method of claim 1 wherein the actinic radiation is a UV radiation having a wavelength below about 2500Å.

3. The method of claim 1 wherein the active radiation is UV radiation having a wavelength below about 2000A.

4. The method of claim 1 wherein the base resin has an aromatic content of from about 0% to 20% by weight.

5. The method of claim 1 wherein the base resin includes substantially no aromatic groups.

6. The method of claim 1 wherein the photoresist is a positive photoresist.

7. The method of claim 1 wherein the photoresist is a negative photoresist.

8. The method of claim 1 wherein the photoresist includes a base resin selected from the group consisting of polyhydroxystyrene, polymethylmethacrylate, polyvinyl phenol,
polyvinyl alcohol, polyvinyl phenol, polynorbonene, poly(p-formyl) oxystyrene, poly (t-butoxycarbonyloxystyrene), polyvinylpyrrolidone, polymethylisoprenylketone, phenol-formaldehyde, polymer, melamine-formaldehyde polymer and physical and chemical combinations thereof.

9. The method of claim 1 wherein the chemically reactive sites are selected from the group consisting of hydroxyl, carboxyl, mercapto, amino, alkylamino, imino, formyl, sulfo and phosphono groups.

10. The method of claim 1 wherein the photoactive component of the photoresist is a photoacid generator selected from the group consisting of diaryliodonium salts, triarylsulfonium salts, substituted aryldiazonium salts, halomethanes, trichlorotriazine, â-naphthol, nitrobenzaldehyde, and polyvinylchloride.

11. The method of claim 1 wherein the step of deprotecting the photoresist comprises subjecting the photoresist to a second exposure to electromagnetic radiation and heating the photoresist to a temperature of from about 100°C to about 150°C.

12. The method of claim 1 wherein the etch protectant includes a member selected from the group consisting of aromatic polycarboxylic acid, aromatic polycarboxylic anhydride and aromatic polycarboxylic acid chloride.

13. The method of claim 1 wherein said etch protectant comprises a compound selected from the group consisting of phthalic acid, phthalic anhydride, isophthalic acid, terephthalic acid, phthalic acid chloride, naphthalic acid, naphthalic anhydride, naphthyl acetic and anthracene dipropionic acid.

14. The method of claim 1 wherein said etch protectant is dissolved in water to form an aqueous solution.

15. The method of claim 1 wherein the step of etching the substrate comprises plasma etching.

16. The method of claim 15 wherein the plasma etching is accomplished with a halogen-containing etch gas.

17. The method of claim 1 further including the step of removing the photoresist after etching.

18. A method for producing a photolithographic structure which comprises:
a) providing a photoresist including a base resin having an aromatic content of from about 0% to about 20% by weight and containing protected active sites which upon deprotection provide reactive sites and a photoactive component which is responsive to electromagnetic radiation having a wavelength of no more than about 2500Å;
b) applying said photoresist to a substrate;
c) exposing selectively patterned areas of said photoresist to an effective first dose of said electromagnetic radiation;
d) exposing said photoresist to a developing agent to create a patterned photoresist;
e) deprotecting the protected active sites of the base resin by subjecting the patterned photoresist to a second dose of the electromagnetic radiation and then heating the patterned photoresist to a temperature of from between 100°C to about 150°C to provide reactive sites;
f) reacting the reactive sites resulting from step (e) with
an aromatic ring-containing etch protectant to incorporate the etch protectant into the structure of the base resin, the etch protectant being a compound selected from the group consisting of aromatic polycarboxylic acid, aromatic polycarboxylic anhydride and aromatic polycarboxylic acid chloride; and
g) etching the substrate.

19. The method of claim 18 wherein the photoresist includes substantially no aromatic groups.

20. The method of claim 19 wherein the electromagnetic radiation has a wavelength less than about 2000Å.

21. The method of claim 18 wherein the etch protectant is a compound selected from the group consisting of phthalic acid, phthalic anhydride, isophthalic acid, terephthalic acid, phthalic acid chloride, naphthalic acid, naphthalic anhydride, naphthyl acetic and anthracene dipropionic acid.
